# EUROPÄISCHE PATENTSCHRIFT

(11) **EP 4 370 941 B1**
(45) Veröffentlichungstag und Bekanntmachung des Hinweises auf die Patenterteilung: **06.08.2025**
(21) Anmeldenummer: 22735431.3
(22) Anmeldetag: 27.06.2022
(51) Int. Cl.: G01R 31/327

(54) **VERFAHREN ZUM ÜBERWACHEN VON KURZSCHLUSS-SCHALTVORGÄNGEN EINER SCHALTUNG EINES STEUERGERÄTS**
METHOD FOR MONITORING SHORT-CIRCUIT SWITCHING PROCESSES OF A CIRCUIT OF A CONTROL DEVICE
PROCÉDÉ DE SURVEILLANCE DE PROCESSUS DE COMMUTATION DE COURT-CIRCUIT DANS UN CIRCUIT DE DISPOSITIF DE COMMANDE

(30) Priorität: 16.07.2021 DE 102021207633
(43) Veröffentlichungstag der Anmeldung: 22.05.2024
(73) Patentinhaber: Robert Bosch GmbH, 70442 Stuttgart (DE)
(72) Erfinder: CHU, Siyun, 71642 Ludwigsburg (DE); HETTRICH, Frank, 71735 Eberdingen (DE); SCHWAERZLE, Andreas, 70563 Stuttgart (DE)
(86) Internationale Anmeldenummer: PCT/EP2022/067559
(87) Internationale Veröffentlichungsnummer: WO 2023/285122

(56) Entgegenhaltungen:
- EP-A1- 3 745 229
- CN-A- 107 976 626
- CN-A- 112 540 292
- US-B1- 6 472 877

## Beschreibung

Die vorliegende Erfindung betrifft ein Verfahren zum Überwachen von Kurzschluss-Schaltvorgängen einer Schaltung eines Steuergeräts, insbesondere in einem Fahrzeug, sowie eine Recheneinheit zu dessen Durchführung.

### Hintergrund der Erfindung

Endstufen bzw. Endstufenschaltungen in Steuergeräten, beispielsweise in (Kraft-)Fahrzeugen, stellen die letzte elektronische Stufe eines Leistungsverstärkers dar, bevor ein verstärktes Signal an eine Last angelegt wird. So können beispielsweise in einem Motorsteuergerät Endstufenschaltungen vorgesehen sein, um zur Ansteuerung von Aktoren erforderliche Leistungen zur Verfügung zu stellen. In dem Steuergerät können die jeweiligen Endstufenschaltungen von einem Mikrocontroller mittels entsprechender Ansteuersignale angesteuert werden.

Um eine (Betriebs-)Sicherheit des Steuergeräts gewährleisten zu können, sollten die Endstufenschaltungen zumeist robust genug gebaut sein, um zumindest einer vorgegebenen Mindestanzahl von (Ein-)Schaltvorgängen im Kurzschlussfall standhalten zu können, d.h. wenn ein Kurzschluss nach Batterie oder Masse vorliegt. Wenn jedoch eine zu hohe Anzahl derartiger Kurzschluss-Schaltvorgänge durchgeführt wird, insbesondere bei einer PWM-Ansteuerung, kann es zu einer Beschädigung oder gar Zerstörung der Endstufe und somit des gesamten Steuergeräts kommen.

Aus der Offenlegungsschrift CN 107 976 626 A ist ein Verfahren zum Überwachen von Schaltvorgängen einer Schaltung bekannt. Es ist dabei insbesondere vorgesehen, eine Lebensdauer eines Relais zu bestimmen. Hierfür wird eine Relaislebensdauer-Erfassungsvorrichtung bereitgestellt, die eine Steuereinheit, eine Ein-Aus-Zähleinheit, eine Mensch-Maschine-Schnittstelleneinheit, eine Relaisansteuereinheit und eine Oszillatoreinheit umfasst. Die Mensch-Maschine-Schnittstelleneinheit zeigt die Lebensdauer der Relaisschalter an.

### Offenbarung der Erfindung

Vor diesem Hintergrund werden ein Verfahren zum Überwachen von Kurzschluss-Schaltvorgängen einer Schaltung eines Steuergeräts sowie eine Recheneinheit zu dessen Durchführung mit den Merkmalen der unabhängigen Patentansprüche vorgeschlagen. Vorteilhafte Ausgestaltungen sind Gegenstand der Unteransprüche sowie der nachfolgenden Beschreibung.

Im Zuge des vorliegenden Verfahrens werden aktuelle Informationen bezüglich des Steuergeräts erfasst und dahingehend ausgewertet, ob ein Kurzschluss-Schaltvorgang vorliegt, d.h. ob die Schaltung einen Einschaltvorgang während eines Kurzschlusses (d.h. ohne Last) durchführt. Wenn im Zuge der Auswertung erkannt wird, dass ein Kurzschluss-Schaltvorgang vorliegt, wird ein Zähler bzw. ein Zählerstand aktualisiert bzw. erhöht, welcher eine Anzahl der über eine Lebensdauer der Schaltung durchgeführten Kurzschluss-Schaltvorgänge charakterisiert bzw. repräsentiert.

Durch Erfassen und Auswerten der Steuergeräte-Informationen kann zweckmäßigerweise im laufenden Betrieb des Steuergeräts erkannt werden, ob es aktuell zu einem Kurzschluss-Schaltvorgang kommt. Der Zählerstand wird somit fortlaufend während der Lebensdauer aktualisiert, wenn ein neuer Kurzschluss-Schaltvorgang erkannt wird.

Anhand des Zählerstands können beispielsweise Maßnahmen zum Schutz der Endstufenschaltung oder zur Behebung von Fehlern durchgeführt werden. Ferner erlaubt der Zählerstand beispielsweise Rückschlüsse darüber, wie hoch die Gefahr einer Beschädigung oder Zerstörung der Endstufe ist. Ferner kann beispielsweise ein Betrieb der Endstufe eingeschränkt oder beeinflusst werden, wenn der der Zählerstand sehr hoch ist und sich beispielsweise einer vorgegebenen Anzahl von erlaubten (Ein-)Schaltvorgängen im Kurzschlussfall annähert.

Der Zählerstand kann zweckmäßigerweise in einer Werkstatt ausgelesen werden und kann beispielsweise eine Fehlersuche oder Reparatur erleichtern. Ferner kann der Zählerstand im Falle einer Beschädigung oder Zerstörung der Endstufe bzw. des Steuergeräts bei einer nachträglichen Ursachensuche behilflich sein. Besonders zweckmäßig kann anhand des Zählerstands überprüft werden, ob ein Garantieanspruch gerechtfertigt ist. Beispielsweise lässt sich anhand des Zählerstands überprüfen, ob ein (End-)Kunde über einen längeren Zeitraum hinweg einen Warnhinweis ignoriert hat, etwa eine aktivierte Motorkontrollleuchte, was zu einer Minderung oder einem Ausschluss einer Garantieleistung durch den (Steuergeräte-)Hersteller führen kann.

Die Informationen bezüglich des Steuergeräts charakterisieren insbesondere den aktuellen Betrieb des Steuergeräts, insbesondere aktuelle Signale des Steuergeräts zur Ansteuerung der Endstufenschaltung, ferner insbesondere aktuelle Fehler bzw. Fehlermeldungen des Steuergeräts. Anhand dieser Informationen kann besonders zweckmäßig rückgeschlossen werden, ob die Schaltung aktuell angesteuert wird und ob aktuell ein Kurzschluss in dem Steuergerät vorliegt. Beispielsweise sind unterschiedliche Maßnahmen zur Kurzschlusserkennung in Endstufen von Fahrzeugsteuergeräten bekannt und teilweise auch vorgeschrieben. Beispielsweise können erfasste Messwerte ausgewertet werden. Beispielsweise kann überprüft werden, ob ein Strom durch die Endstufenschaltung einen zulässigen Grenzwert überschreitet. Ferner kann beispielsweise auf Fehlerdiagnosen bzw. Diagnosefunktionen des Steuergeräts zum Erkennen von Fehlerzuständen zurückgegriffen werden.

Vorteilhafterweise wird in Abhängigkeit von dem Zählerstand bzw. von einem aktuellen Wert des Zählerstands eine Priorisierung von Kurzschluss-Schaltvorgängen durchgeführt, die während eines vorgegebenen Diagnoseintervalls, insbesondere während eines aktuellen Diagnoseintervalls durchgeführt werden bzw. durchgeführt werden sollen oder dürfen. Beispielsweise können diese einzelnen Diagnoseintervalle jeweils einem Fahrzyklus des (Kraft-)Fahrzeugs entsprechen. Zweckmäßigerweise werden Kurzschluss-Schaltvorgänge priorisiert, die im Zuge einer Fehlerdiagnose bzw. Fehlererkennung durchgeführt werden. Anhand derartiger Schaltvorgänge zur Fehlerdiagnose kann insbesondere überprüft bzw. erkannt werden, ob der Kurzschluss noch vorliegt oder ob das Steuergerät nach einer Heilung wieder fehlerfrei ohne Kurzschluss funktioniert. Mit Hilfe dieser Priorisierung kann zweckmäßigerweise eingestellt bzw. vorgegeben werden, wie häufig pro Diagnoseintervall überprüft wird, ob der Kurzschluss noch vorliegt. Je höher die zugewiesene Priorität, desto häufiger wird eine Fehlerdiagnose pro Diagnoseintervall durchgeführt. Insbesondere kann somit mit zunehmender Lebenszeit der Schaltung die Anzahl der pro Diagnoseintervall durchgeführten Fehlerdiagnosen stets reduziert werden, um unnötige viele Kurzschluss-Schaltvorgänge und eine Beschädigung oder Zerstörung der Endstufenschaltung zu vermeiden.

So kann beispielsweise bei einem niedrigen Wert des Zählerstands, welcher insbesondere einen Beginn der Lebensdauer der Endstufe widerspiegelt, die Fehlerdiagnose oder Fehlererkennung höher priorisiert werden, als bei einem höheren Wert des Zählerstands während einer späteren Phase der Endstufenlebensdauer, da zu Beginn der Lebensdauer die Chancen einer Heilung bzw. Behebung des Kurzschlusses größer sind als gegen Ende der Lebensdauer. Beispielsweise kann somit durch eine hohe zugewiesene Priorität bei geringem Zählerstand mehrmals pro Diagnoseintervall überprüft werden, ob der Kurzschluss noch vorliegt. Bei höherem Zählerstand können durch eine geringere zugewiesene Priorität insbesondere weniger oder keine Schaltvorgänge zur Fehlerdiagnose pro Diagnoseintervall erlaubt werden, um unnötige Belastungen oder gar einen Defekt der Endstufenschaltung zu vermeiden. Beispielsweise kann einem Schaltvorgang zur Fehlerdiagnose eine hohe oder höchste Priorität zugewiesen werden, wenn der Zählerstand unterhalb eines vorgegebenen Grenzwerts liegt. Je mehr sich der Zählerstand diesem Grenzwert annähert, desto geringer kann die Priorität gewählt werden.

Herkömmlicherweise ist die Anzahl von Kurzschluss-Schaltvorgängen, die pro Diagnoseintervall durchgeführt werden, auf eine fest vorgegebene Maximalzahl beschränkt, beispielsweise abhängig von einem Typ der jeweiligen Endstufe, einer Spannungsversorgung, einem angewendeten System, einer Konfiguration, verwendeter Sensoren, einer aktuellen Umgebungstemperatur usw. Herkömmlicherweise erfolgt bei einem erkannten Kurzschluss eine Fehlerbenachrichtigung, insbesondere durch Aktivieren einer Motorkontrollleuchte, und es wird in fest vorgegebenen Zeitabständen während eines Diagnoseintervalls durch weitere Einschaltvorgänge überprüft, ob der Kurzschluss noch vorliegt, bis zu der fest vorgegebenen Maximalzahl von Kurzschluss-Schaltvorgängen pro Diagnoseintervall. Ist der Kurzschluss bis dahin nicht behoben, wird eine entsprechende Funktion des Steuergeräts für den Rest des Diagnoseintervalls oftmals pauschal dauerhaft deaktiviert. Auch wenn nun noch eine Heilung des Kurzschlusses in diesem Diagnoseintervall erfolgen sollte, kann dies nicht mehr festgestellt werden und die entsprechende Funktion bleibt dennoch deaktiviert. Erst in einem folgenden Diagnoseintervall darf wieder eine Überprüfung des Kurzschlusses durchgeführt werden.

Im Gegensatz dazu kann mit Hilfe des Zählerstandes im Rahmen des vorliegenden Verfahrens dynamisch angepasst werden, wie oft pro Diagnoseintervall auf Fehler geprüft wird, insbesondere basierend auf der Lebenszeit. Da zu Beginn der Lebenszeit eine Heilung wahrscheinlicher ist als mit hoher Lebenszeit, wird hier öfter überprüft, damit eine etwaige Heilung des Kurzschlusses erkannt werden kann und Steuergerätefunktionen nicht unnötig pauschal deaktiviert werden, obwohl ein Kurzschluss vielleicht schon gar nicht mehr vorliegt. Mit hoher Lebenszeit kann dann nur noch selten oder gar nicht mehr pro Diagnoseintervall auf Fehler überprüft werden, da hier eine Heilung weniger wahrscheinlich ist, dafür aber die Gefahr der Zerstörung der Endstufenschaltung erhöht ist.

Vorzugsweise wird in Abhängigkeit von dem Zählerstand bzw. von einem aktuellen Wert des Zählerstands eine Anzahl von Kurzschluss-Schaltvorgängen begrenzt, die während eines Diagnoseintervalls oder eines Fahrzyklus, insbesondere während eines aktuellen Diagnoseintervalls oder Fahrzyklus durchgeführt werden bzw. durchgeführt werden sollen oder dürfen. Wie obig erläutert, können auf herkömmliche Weise Kurzschluss-Schaltvorgänge zur Fehlerdiagnose pro Diagnoseintervall oftmals pauschal auf einen statischen, festen Wert begrenzt werden. Im Gegensatz dazu kann durch Einführung des Zählerstands besonders zweckmäßig eine Begrenzung der Anzahl von erlaubten Kurzschluss-Schaltvorgängen pro Diagnoseintervall dynamisch über die Lebensdauer der Schaltung erfolgen, insbesondere dynamisch angepasst an die Anzahl von Kurzschluss-Schaltvorgängen, welche die Schaltung während ihrer bisherigen Lebenszeit bereits durchgeführt hat.

Gemäß einer bevorzugten Ausführungsform wird der Zählerstand bzw. der aktuelle Wert des Zählerstands mit einem vorgegebenen Schwellwert verglichen. Beispielsweise kann dieser Schwellwert abhängig von einer Mindestanzahl von Kurzschluss-Schaltvorgängen vorgegeben werden, welcher die Endstufenschaltung während ihrer Lebensdauer mindestens standhalten soll. Der Schwellwert kann beispielsweise repräsentieren, dass sich die Anzahl der bisher durchgeführten Kurzschluss-Schaltvorgänge dieser Mindestanzahl zunehmend annähert, so dass eine zunehmende Gefahr einer Beschädigung der Schaltung gegeben ist. Bei Erreichen oder Überschreiten des Schwellwerts können insbesondere weitere Einschaltvorgänge unterbunden bzw. verboten werden. Bevorzugt werden in Abhängigkeit von dem Vergleich des aktuellen Zählerstandwerts mit dem vorgegebenen Schwellwert die Priorisierung der Kurzschluss-Schaltvorgänge durchgeführt und/oder die Anzahl der Kurzschluss-Schaltvorgängen begrenzt. Insbesondere erfolgt somit nicht eine pauschale, statische Begrenzung von Schaltvorgängen pro Diagnoseintervall, sondern es kann dynamisch angepasst werden, welche bzw. wie viele Schaltvorgänge im Kurzschlussfall erlaubt sind, zweckmäßigerweise abhängig von der aktuellen Lebenszeit der Endstufenschaltung.

Insbesondere kann als Schwellwert wie obig erläutert ein Maximalwert für eine Anzahl von Kurzschluss-Schaltvorgängen vorgegeben werden, die während eines Diagnoseintervalls durchgeführt werden dürfen.

Besonders bevorzugt wird der Schwellwert abhängig von einer Anzahl von durchgeführten Diagnoseintervallen vorgegeben. Zweckmäßigerweise wird der Schwellwert somit dynamisch abhängig von der bisherigen Lebenszeit der Endstufenschaltung angepasst.

Vorteilhafterweise wird der Schwellwert, insbesondere für ein aktuelles Diagnoseintervall, vorgegeben in Abhängigkeit von einem (z.B. linearen oder logarithmischen) Zusammenhang zwischen einer Anzahl von erlaubten Kurzschluss-Schaltvorgängen und einer von bisher durchgeführten Diagnoseintervallen. Mittels eines logarithmischen Zusammenhangs kann insbesondere zu Beginn der Endstufenlebensdauer eine hohe Anzahl von Kurzschluss-Schaltvorgängen pro Diagnoseintervall erlaubt werden. Mit Annäherung an eine entsprechende Mindestanzahl von Kurzschluss-Schaltvorgängen, welcher die Endstufenschaltung während ihrer Lebensdauer mindestens standhalten soll, können zunehmend weniger Kurzschluss-Schaltvorgänge pro Diagnoseintervall erlaubt werden.

Zweckmäßigerweise wird der Schwellwert, insbesondere für ein aktuelles Diagnoseintervall, vorgegeben in Abhängigkeit von einem Maximalwert für eine Anzahl von Kurzschluss-Schaltvorgängen, die während der Lebensdauer der Schaltung durchgeführt werden dürfen, und insbesondere von einem Abstand zwischen einer Anzahl von Kurzschluss-Schaltvorgängen und dem Maximalwert für eine Anzahl von Kurzschluss-Schaltvorgängen, die während der Lebensdauer der Schaltung durchgeführt werden dürfen. Mittels eines solchen Zusammenhangs kann insbesondere bei großem Abstand vom Maximalwert eine hohe Anzahl von Kurzschluss-Schaltvorgängen pro Diagnoseintervall erlaubt werden. Mit Annäherung an den Maximalwert werden zunehmend weniger Kurzschluss-Schaltvorgänge pro Diagnoseintervall erlaubt, um die Schaltung zu schützen.

Bevorzugt wird der Zählerstand nur dann erhöht, wenn im Zuge der Auswertung erkannt wird, dass ein Highside-Schalter der Schaltung einen Einschaltvorgang während eines Kurzschlusses gegen Masse durchführt und/oder dass ein Lowside-Schalter der Schaltung einen Einschaltvorgang während eines Kurzschlusses gegen Versorgungsspannung durchführt. Bei masseseitig verbauten Endstufen bzw. bei Lowside-Schaltern, die mit einem Anschluss mit Masse verbunden sind bzw. bei welchem die Last zwischen dem Schalter und Versorgungsspannung angeordnet ist, können insbesondere Einschaltimpulse bei einem Kurzschluss nach Versorgungsspannung schädigend für die Schaltung wirken, so dass in diesem Fall besonders zweckmäßig Schaltvorgänge während eines derartigen Kurzschlussfalls mit dem Zählerstand dokumentiert werden. Bei spannungsseitig verbauten Endstufen, also bei Highside-Schaltern, die mit einem Anschuss mit der Versorgungsspannung verbunden sind bzw. bei welchem die Last zwischen dem Schalter und Masse angeordnet ist, können hingegen insbesondere Einschaltimpulse bei Kurzschlüssen nach Masse schädigend wirken, so dass in diesem Fall zweckmäßigerweise Schaltvorgänge bei Massenkurzschlüssen mittels des Zählerstands gezählt werden.

Eine erfindungsgemäße Recheneinheit, z.B. ein Steuergerät eines (Kraft-)Fahrzeugs, ist, insbesondere programmtechnisch, dazu eingerichtet, ein erfindungsgemäßes Verfahren durchzuführen.

Weitere Vorteile und Ausgestaltungen der Erfindung ergeben sich aus der Beschreibung und der beiliegenden Zeichnung.

Die Erfindung ist anhand von Ausführungsbeispielen in der Zeichnung schematisch dargestellt und wird im Folgenden unter Bezugnahme auf die Zeichnung beschrieben.

### Kurze Beschreibung der Zeichnungen

- Figur 1: zeigt schematisch zeigt schematisch ein Steuergerät mit einer Endstufenschaltung, das dazu eingerichtet ist, eine bevorzugte Ausführungsform eines erfindungsgemäßen Verfahrens durchzuführen.
- Figur 2: zeigt schematisch eine bevorzugte Ausführungsform eines erfindungsgemäßen Verfahrens als ein Blockdiagramm.
- Figur 3: zeigt schematisch ein Diagramm einer Anzahl von erlaubten Kurzschluss-Schaltvorgänge aufgetragen gegen eine Anzahl von durchgeführten Fahrzyklen, welches im Zuge einer bevorzugten Ausführungsform eines erfindungsgemäßen Verfahrens bestimmt werden kann.

### Ausführungsform(en) der Erfindung

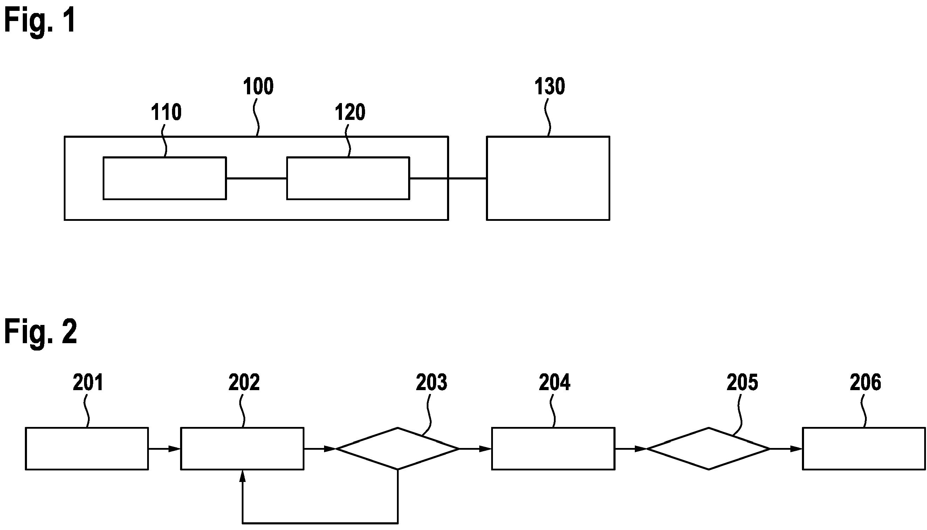

In Figur 1 ist ein Steuergerät eines (Kraft-)Fahrzeugs schematisch dargestellt und mit 100 bezeichnet.

Das Steuergerät 100 kann beispielsweise als ein Motorsteuergerät zum Ansteuern eines Verbrennungsmotors 130 vorgesehen sein und weist einen Mikrocontroller 110 und eine Halbleiter-Endstufenschaltung 120 auf, beispielsweise in Form einer MOSFET-Brückenschaltung mit Highside-Schaltern und/oder Lowside-Schaltern. Mittels entsprechender Ansteuerimpulse kann der Mikrocontroller 110 diese Halbleiter-Schaltelemente der Endstufenschaltung 120 ansteuern.

Die Endstufe 120 ist darauf ausgelegt, einer Mindestanzahl von Kurzschluss-Schaltvorgängen ohne Beschädigungen standhalten zu können. Wird diese Anzahl von Kurzschluss-Schaltvorgängen überschritten, kann eine erhöhte Gefahr einer Beschädigung oder gar einer Zerstörung der Endstufe 120 und des Steuergeräts 100 bestehen.

Um dieser Gefahr vorzubeugen, ist das Steuergerät 100, insbesondere programmtechnisch, dazu eingerichtet, eine bevorzugte Ausführungsform eines erfindungsgemäßen Verfahrens durchzuführen, welches schematisch in Figur 2 als ein Blockdiagramm dargestellt ist und nachfolgend erläutert werden soll.

In einem Schritt 201 wird das Steuergerät 100 bzw. das entsprechende (Kraft-)Fahrzeug regulär betrieben. In Schritt 202 werden Informationen bezüglich des Steuergeräts 100 erfasst, insbesondere Informationen, welche den aktuellen Betrieb des Steuergeräts charakterisieren. Insbesondere betreffen diese Informationen aktuelle Signale bzw. Ansteuerimpulse des Mikrocontrollers 110 zur Ansteuerung der Endstufenschaltung 120 sowie aktuelle vorliegende Fehler des Steuergeräts 100. Beispielsweise werden als diese Informationen ein Tastverhältnis eines Ansteuersignals von Halbleiter-Schaltelementen, Ströme durch Halbleiter-Schaltelemente Fehlerspeicherinformationen bzw. Einträge in einem Fehlerspeicher erfasst.

In einem Schritt 203 werden diese Informationen dahingehend ausgewertet, ob ein Kurzschluss-Schaltvorgang vorliegt, ob also von dem Mikrocontroller 110 ein Ansteuerimpuls bzw. ein (Ein-)Schaltimpuls an die Endstufenschaltung 120 ausgegeben wird, während in der Endstufenschaltung 120 ein Fehlerzustand in Form eines Kurzschlusses vorliegt, insbesondere ob somit ein Highside-Schalter der Endstufenschaltung 120 einen Einschaltvorgang gegen Masse durchführt und/oder ob ein Lowside-Schalter einen Einschaltvorgang gegen Versorgungsspannung (z.B. Batterie) durchführt.

Solange dies nicht der Fall ist und kein derartiger Kurzschluss-Schaltvorgang vorliegt, werden weiterhin die Informationen bezüglich des Steuergeräts in Schritt 202 erfasst und in Schritt 203 ausgewertet.

Wenn hingegen in Schritt 203 erkannt wird, dass ein derartiger Kurzschluss-Schaltvorgang vorliegt, wird in Schritt 204 ein Zählerstand aktualisiert bzw. erhöht, welcher eine Anzahl der über die Lebensdauer der Endstufenschaltung 120 durchgeführten Kurzschluss-Schaltvorgänge charakterisiert. Der aktuelle Wert dieses Zählerstands entspricht somit der Anzahl aller Kurzschluss-Schaltvorgänge, welche die Endstufenschaltung 120 seit Beginn ihrer Lebensdauer bzw. seit ihrer erstmaligen Inbetriebnahme in dem Steuergerät 100 durchgeführt hat.

Dieser Zählerstand kann beispielsweise in einer Werkstatt ausgelesen werden und zur Fehlersuche, Reparatur oder Überprüfung eines Garantieanspruchs herangezogen werden. Beispielsweise kann mit Hilfe des Zählerstands überprüft werden, ob ein Fahrer des Fahrzeugs über einen längeren Zeitraum hinweg einen Warnhinweis ignoriert hat, z.B. eine aktivierte Motorkontrollleuchte, was zu einer Minderung oder einem Ausschluss einer Garantieleistung des Herstellers des Steuergeräts 100 führen kann.

In Schritt 205 wird der Zählerstand bzw. der aktuelle Wert des Zählerstands mit einem Schwellwert verglichen, insbesondere mit einem Maximalwert für die Anzahl von Kurzschluss-Schaltvorgängen, die während eines Diagnoseintervalls oder eines Fahrzyklus zur Fehlerdiagnose durchgeführt werden dürfen.

Auf herkömmliche Weise wird die Anzahl von erlaubten Kurzschluss-Schaltvorgängen pro Diagnoseintervall oftmals statisch auf einen konstanten, fixen Wert begrenzt. Die Einführung des vorliegenden Zählerstands ermöglicht es hingegen, die erlaubten Kurzschluss-Schaltvorgänge pro Diagnoseintervall flexibel und dynamisch anzupassen, abhängig von der Anzahl von Kurzschluss-Schaltvorgängen, welche die Schaltung 120 während ihrer bisherigen Lebenszeit bereits durchgeführt hat.

Der Schwellwert wird insbesondere abhängig von einer Anzahl von Diagnoseintervallen vorgegeben, welche die Endstufenschaltung 120 bzw. das Fahrzeug bereits durchgeführt hat. Beispielsweise kann in frühen Phasen zu Beginn der Lebensdauer der Endstufenschaltung 120 eine höhere Anzahl von Kurzschluss-Schaltvorgängen pro Diagnoseintervall erlaubt werden als zu späteren Phasen, da zu Beginn der Lebensdauer eine größere Chance auf eine Heilung des Kurzschlusses besteht. Insbesondere wird der Schwellwert für das aktuelle Diagnoseintervall abhängig von einem linearen oder logarithmischen Zusammenhang zwischen der Anzahl von erlaubten Kurzschluss-Schaltvorgängen und der Anzahl von durchgeführten Diagnoseintervallen vorgegeben.

Basierend auf dem Schwellwertvergleich 205 wird in Schritt 206 die Anzahl von Kurzschluss-Schaltvorgängen begrenzt, welche in dem aktuellen Diagnoseintervall zur Fehlerdiagnose noch durchgeführt werden dürfen. Ferner kann in Schritt 206 basierend auf dem Vergleichsergebnis eine Priorisierung einzelner Kurzschluss-Schaltvorgänge durchgeführt werden. So können beispielsweise zu Beginn der Lebensdauer der Schaltung 120 Kurzschluss-Schaltvorgängen im Zuge der Fehlerdiagnose eine höhere oder höchste Priorität zugewiesen werden und es kann eine hohe oder gar unbegrenzte Anzahl derartiger Schaltvorgänge zur Fehldiagnose pro Diagnoseintervall erlaubt werden, da in diesem Fall hohe Chancen auf eine Heilung bzw. auf eine erfolgreiche Fehlerbehebung bestehen. Zu späteren Phasen der Lebensdauer nach einer hohen Anzahl von durchgeführten Diagnoseintervallen kann die Priorität derartiger Kurzschluss-Schaltvorgänge zur Fehlerdiagnose beispielsweise geringer gewählt werden und es kann beispielsweise nur ein Versuch bzw. ein Schaltvorgang zur Fehlerdiagnose vorgegeben werden, um eine mögliche Beschädigung oder Zerstörung des Steuergeräts 100 zu vermeiden.

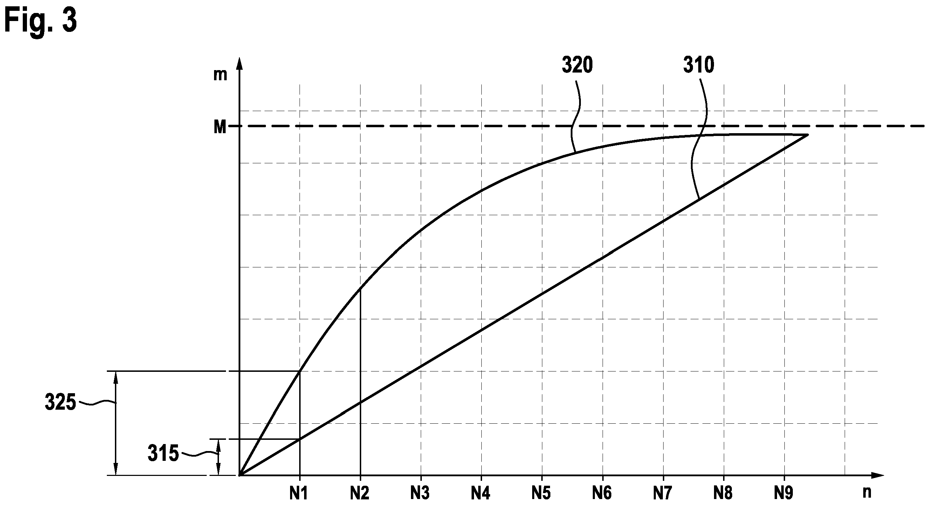

In Figur 3 ist ein Diagramm der Anzahl m von erlaubten Kurzschluss-Schaltvorgängen aufgetragen gegen die Anzahl n von durchgeführten Diagnoseintervallen schematisch dargestellt.

Kurve 310 stellt einen entsprechenden linearen Zusammenhang und Kurve 320 einen entsprechenden logarithmischen Zusammenhang dar, abhängig von welchen in Schritt 205 der Schwellwert für das aktuelle Diagnoseintervall vorgegeben werden kann.

Mit M ist eine Mindestanzahl von Kurzschluss-Schaltvorgängen bezeichnet, welcher die Endstufenschaltung 120 während ihrer Lebensdauer mindestens standhalten soll.

Mit 315 ist beispielsweise die Anzahl von erlaubten Kurzschluss-Schaltvorgängen für das Diagnoseintervall N1 gemäß dem linearem Zusammengang 310 bezeichnet und mit 325 die Anzahl von erlaubten Kurzschluss-Schaltvorgängen für das Diagnoseintervall N1 gemäß dem logarithmischen Zusammengang 320.

Gemäß dem logarithmischen Zusammenhang 320 werden insbesondere zu Beginn der Lebensdauer der Schaltung 120 mehr Kurzschluss-Schaltvorgänge pro Diagnoseintervall erlaubt als gemäß dem linearen Zusammenhang 310. Ferner werden gemäß dem logarithmischen Zusammenhang 320 mit zunehmender Annäherung an die Mindestanzahl M stets weniger Kurzschluss-Schaltvorgänge pro Diagnoseintervall erlaubt.

Beispielsweise kann ausgehend von dem logarithmischen Zusammenhang 320 mittels einer Taylor-Expansion die Anzahl von erlaubten Kurzschluss-Schaltvorgängen pro Diagnoseintervall online während des aktuellen Diagnoseintervalls ermittelt werden.

Eine qualitativ ähnliche Kurve ergibt sich, wenn der Schwellwert in Abhängigkeit von einem Abstand zwischen einer Anzahl von Kurzschluss-Schaltvorgängen und dem Maximalwert für eine Anzahl von Kurzschluss-Schaltvorgängen, die während der Lebensdauer der Schaltung durchgeführt werden dürfen, vorgegeben wird. Damit kann insbesondere bei großem Abstand vom Maximalwert eine hohe Anzahl von Kurzschluss-Schaltvorgängen pro Diagnoseintervall erlaubt werden. Mit Annäherung an den Maximalwert werden zunehmend weniger Kurzschluss-Schaltvorgänge pro Diagnoseintervall erlaubt, um die Schaltung zu schützen.

## Patentansprüche

1. Verfahren zum Überwachen von Kurzschluss-Schaltvorgängen einer Schaltung (120), insbesondere einer Endstufenschaltung (120) eines Steuergeräts (100), **dadurch gekennzeichnet, dass**
Informationen bezüglich eines Steuergeräts (100) erfasst (202) und dahingehend ausgewertet (203) werden, ob ein Kurzschluss-Schaltvorgang vorliegt, wobei die Schaltung (120) einen Einschaltvorgang während eines Kurzschlusses durchführt, und
wobei, wenn im Zuge der Auswertung erkannt wird, dass ein Kurzschluss-Schaltvorgang vorliegt, ein Zählerstand aktualisiert wird (204), welcher eine Anzahl der über eine Lebensdauer der Schaltung (120) durchgeführten Kurzschluss-Schaltvorgänge charakterisiert.

2. Verfahren nach Anspruch 1, wobei in Abhängigkeit von dem Zählerstand eine Priorisierung oder Begrenzung von Kurzschluss-Schaltvorgängen durchgeführt wird (206), die während eines Diagnoseintervalls durchgeführt werden, insbesondere von Kurzschluss-Schaltvorgängen, die im Zuge einer Fehlerdiagnose durchgeführt werden.

3. Verfahren nach Anspruch 1 oder 2, wobei der Zählerstand mit einem vorgegebenen Schwellwert verglichen wird (205), insbesondere mit einem vorgegebenen Maximalwert für eine Anzahl von Kurzschluss-Schaltvorgängen, die während eines Diagnoseintervalls durchgeführt werden dürfen.

4. Verfahren nach Anspruch 3, wobei der Schwellwert abhängig von einer Anzahl von Diagnoseintervallen vorgegeben wird

5. Verfahren nach Anspruch 4, wobei der Schwellwert vorgegeben wird in Abhängigkeit von einem Zusammenhang (310) zwischen einer Anzahl von Kurzschluss-Schaltvorgängen (m) und der Anzahl von Diagnoseintervallen (n)

6. Verfahren nach einem der Ansprüche 3 bis 5, wobei der Schwellwert abhängig von einem Maximalwert für eine Anzahl von Kurzschluss-Schaltvorgängen, die während der Lebensdauer der Schaltung (120) durchgeführt werden dürfen, vorgegeben wird.

7. Verfahren nach Anspruch 6, wobei der Schwellwert vorgegeben wird in Abhängigkeit von einem Abstand zwischen einer Anzahl von Kurzschluss-Schaltvorgängen (m) und dem Maximalwert für eine Anzahl von Kurzschluss-Schaltvorgängen, die während der Lebensdauer der Schaltung (120) durchgeführt werden dürfen

8. Verfahren nach einem der Ansprüche 3 bis 7, wobei in Abhängigkeit von dem Vergleich (205) die Priorisierung von Kurzschluss-Schaltvorgängen durchgeführt wird (206) und/oder die Anzahl von Kurzschluss-Schaltvorgängen begrenzt wird (206).

9. Verfahren nach einem der vorstehenden Ansprüche, wobei der Zählerstand aktualisiert wird (204), wenn im Zuge der Auswertung erkannt wird, dass ein Highside-Schalter der Schaltung (120) einen Einschaltvorgang während eines Kurzschlusses gegen Masse durchführt und/oder dass ein Lowside-Schalter der Schaltung (120) einen Einschaltvorgang während eines Kurzschlusses gegen Batterie durchführt.

10. Recheneinheit (100), die dazu eingerichtet ist, alle Verfahrensschritte eines Verfahrens nach einem der vorstehenden Ansprüche durchzuführen.

## Claims

1. Method for monitoring short-circuit switching operations of a circuit (120), in particular an output stage circuit (120) of a control device (100), **characterized in that**
information relating to a control device (100) is captured (202) and evaluated (203) in order to determine whether there is a short-circuit switching operation present, wherein the circuit (120) carries out a switch-on operation during a short circuit, and
wherein, if, in the course of the evaluation, it is detected that a short-circuit switching operation is present, a counter reading that characterizes a number of short-circuit switching operations carried out over a service life of the circuit (120) is updated (204).

2. Method according to Claim 1, wherein short-circuit switching operations that are carried out during a diagnostic interval, in particular short-circuit switching operations that are carried out in the course of a fault diagnosis, are prioritized or limited depending on the counter reading (206).

3. Method according to Claim 1 or 2, wherein the counter reading is compared with a predetermined threshold value (205), in particular with a predetermined maximum value for a number of short-circuit switching operations that may be carried out during a diagnostic interval.

4. Method according to Claim 3, wherein the threshold value is predetermined depending on a number of diagnostic intervals.

5. Method according to Claim 4, wherein the threshold value is predetermined depending on a relationship (310) between a number of short-circuit switching operations (m) and the number of diagnostic intervals (n).

6. Method according to one of Claims 3 to 5, wherein the threshold value is predetermined depending on a maximum value for a number of short-circuit switching operations that may be carried out during the service life of the circuit (120).

7. Method according to Claim 6, wherein the threshold value is predetermined depending on a difference between a number of short-circuit switching operations (m) and the maximum value for a number of short-circuit switching operations that may be carried out during the service life of the circuit (120).

8. Method according to one of Claims 3 to 7, wherein short-circuit switching operations are prioritized (206) and/or the number of short-circuit switching operations is limited (206) depending on the comparison (205).

9. Method according to one of the preceding claims, wherein the counter reading is updated (204) if, in the course of the evaluation, it is detected that a high-side switch of the circuit (120) carries out a switch-on operation during a short circuit to ground and/or that a low-side switch of the circuit (120) carries out a switch-on operation during a short circuit to battery.

10. Computing unit (100), which is designed to carry out all of the method steps of a method according to one of the preceding claims.

## Revendications

1. Procédé de surveillance des processus de commutation en court-circuit d'un circuit (120), notamment d'un circuit d'étage final (120) d'un contrôleur (100), **caractérisé en ce que**
des informations relatives à un contrôleur (100) sont acquises (202) et évaluées (203) afin de déterminer si un processus de commutation en court-circuit est présent, le circuit (120) effectuant un processus de mise en circuit pendant un court-circuit, et
s'il est reconnu qu'un processus de commutation en court-circuit est présent dans le cadre de l'évaluation, une valeur de compteur étant actualisée (204), laquelle caractérise un nombre des processus de commutation en court-circuit effectuées pendant une durée de vie du circuit (120).

2. Procédé selon la revendication 1, une priorisation ou une limitation deproces-sus de commutation en court-circuit qui sont réalisés pendant un intervalle de diagnostic, notamment de processus de commutation en court-circuit qui sont réalisés dans le cadre d'un diagnostic d'erreur, étant effectuée (206) en fonction de la valeur du compteur.

3. Procédé selon la revendication 1 ou 2, la valeur du compteur étant comparée à une valeur de seuil prédéfinie (205), notamment à une valeur maximale prédéfinie pour un nombre de processus de commutation en court-circuit dont l'exécution est autorisée pendant un intervalle de diagnostic.

4. Procédé selon la revendication 3, la valeur de seuil étant prédéfinie en fonction d'un nombre d'intervalles de diagnostic.

5. Procédé selon la revendication 4, la valeur de seuil étant prédéfinie en fonction d'une relation (310) entre un nombre de processus de commutation en court-circuit (m) et le nombre d'intervalles de diagnostic (n).

6. Procédé selon l'une des revendications 3 à 5, la valeur de seuil étant prédéfinie en fonction d'une valeur maximale pour un nombre de processus de commutation en court-circuit dont l'exécution est autorisée pendant la durée de vie du circuit (120).

7. Procédé selon la revendication 6, la valeur de seuil étant prédéfinie en fonction d'un écart entre un nombre de processus de commutation en court-circuit (m) et la valeur maximale pour un nombre de processus de commutation en court-circuit dont l'exécution est autorisée pendant la durée de vie du circuit (120).

8. Procédé selon l'une des revendications 3 à 7, la priorisation de processus de commutation en court-circuit étant effectuée (206) et/ou le nombre de processus de commutation en court-circuit étant limité (206) en fonction de la comparaison (205).

9. Procédé selon l'une des revendications précédentes, la valeur du compteur étant actualisée (204) lorsqu'il est reconnu, dans le cadre de l'évaluation, qu'un commutateur côté haut potentiel du circuit (120) effectue un processus de mise en circuit pendant un court-circuit à la masse et/ou qu'un commutateur côté bas potentiel du circuit (120) effectue un processus de mise en circuit pendant un court-circuit à la batterie.

10. Unité de calcul (100) qui est conçue pour exécuter toutes les étapes de procédé d'un procédé selon l'une des revendications précédentes.
